Europäisches Patentamt

European Patent Office

Office européen des brevets

(11) Veröffentlichungsnummer : **0 088 045**
**B1**

# (12) EUROPÄISCHE PATENTSCHRIFT

(45) Veröffentlichungstag der Patentschrift :
01.10.86

(21) Anmeldenummer : 83810057.6

(22) Anmeldetag : 09.02.83

(51) Int. Cl.⁴ : **H 01 L 21/90, H 01 L 23/52**

(54) Verfahren zur Herstellung elektrisch leitender Bereiche in integrierten monolythischen Halbleiteranordnungen sowie danach hergestellte Halbleiteranordnung hoher Packungsdichte.

(30) Priorität : 19.02.82 CH 1036/82

(43) Veröffentlichungstag der Anmeldung :
07.09.83 Patentblatt 83/36

(45) Bekanntmachung des Hinweises auf die Patenterteilung : 01.10.86 Patentblatt 86/40

(84) Benannte Vertragsstaaten :
AT BE CH DE FR GB IT LI LU NL SE

(56) Entgegenhaltungen :
DE-A- 2 927 824
US-A- 4 240 094
ELECTRONIC DESIGN, Band 28, Nr. 23, November 1980, Seiten 63-66, Minnesota, USA D. BURSKY: "E-beam, laser processes promise scaled memories and FETs"

(73) Patentinhaber : LASARRAY HOLDING AG
CH-8512 Thundorf (CH)

(72) Erfinder : Percival, Richard
Johannes-Hirt-Strasse 31
CH-8804 Au/ZH (CH)
Erfinder : Uhlmann, Ernst
Am Sonnenberg 6
CH-9507 Stettfurt (CH)

(74) Vertreter : Frauenknecht, Alois J. et al
c/o PPS Polyvalent Patent Service AG Mellingerstrasse 1
CH-5400 Baden (CH)

**Beschreibung**

Die vorliegende Erfindung bezieht sich auf ein Verfahren nach dem Oberbegriff des Anspruchs 1 sowie auf eine Halbleiteranordnung nach Anspruch 7.

Bei der Herstellung kundenspezifischer integrierter Schaltungen, insbesondere bei kleineren und mittleren Stückzahlen, werden vorfabrizierte Siliziumscheiben (Wafer) verwendet, welche mehrfach vorhandene P- und N- resp. N- und P-Strukturen aufweisen, und deren Kontaktflächen mit einer auf einer Siliziumoxidschicht aufgebrachten Aluminiumschicht galvanisch leitend verbunden sind. Die Verbindung zwischen den Kontaktflächen und der Aluminiumschicht geschieht über sogenannte Kontaktfenster, die in der Siliziumoxidschicht wenigstens partiell regelmässig angeordnet und auf der Aluminiumschicht sichtbar sind und mit den Kontaktflächen eine leitende Verbindung bilden.

Bekanntlich kann eine Logik- oder Analogschaltung durch den Fachmann, mittels leitender Verbindungen in einer XY-Ebene zwischen den einzelnen Kontaktflächen, realisiert werden. Die hierfür notwendigen leitenden Bereiche werden in einer notorisch bekannten Photo-Ätztechnik aufgrund einer relativ aufwendigen Photomaske erstellt.

Diese bekannte Technik erfordert einen relativ grossen Aufwand, da die Photomaske für jeden einzelnen Anwendungsfall speziell erstellt werden muss.

Aus der DE-A-2 927 824 ist ein Verfahren zum Herstellen einer SOS-Struktur bekannt, bei dem eine elektrisch leitende Schicht Linienförmig abgetragen wird, so daß insulare leitende Bereiche entstehen.

Es ist daher Aufgabe der Erfindung, ein Verfahren zur Herstellung integrierter Schaltungen zu schaffen, welches wirtschaftlich und rasch ist.

Dementsprechend soll dieses Verfahren die Herstellung integrierter Schaltungen erlauben, ohne dass spezielle, aufwendige Photomasken notwendig sind.

Diese Aufgabe wird nach dem erfindungsgemässen Verfahren dadurch gelöst, dass in einem ersten Verfahrensschritt die galvanisch leitende Schicht mit Aussparungen in einem vorgegebenen Raster hergestellt wird, deren Rasterabstand zumindest annähernd der minimalen Breite eines zu erzielenden galvanisch leitenden Bereichs entspricht, und dass in einem zweiten Verfahrensschritt die leitende Schicht im Gebiet hintereinander angeordneter Aussparungen soweit linienförmig abgetragen wird, bis ein insularer leitender Bereich entsteht.

Hinsichtlich der integrierten Halbleiteranordnung wird diese Aufgabe dadurch gelöst, dass die galvanisch leitende Schicht in einem vorgegebenen Raster angeordnete Aussparungen enthält, und dass diese Aussparungen End-, Verbindungs- und/oder Eckpunkte insularer leitender Bereiche sind.

Nachfolgend werden anhand schematischer Zeichnungen Ausführungsbeispiele des erfindungsgemässen Verfahrens sowie der Halbleiteranordnung näher beschrieben.

Es zeigt:

Figur 1 die vereinfachte Darstellung einer Draufsicht auf eine Siliziumscheibe mit einem durch gestrichelte Linien abgegrenzten Kristallplättchen, wobei die randseitigen Anschlüsse aus zeichnerischen Gründen weggelassen wurden,

Figur 2 einen Schnitt durch eine beispielsweise Halbleiteranordnung in einer Ladungsverschiebe-Schaltung,

Figur 3 eine Draufsicht auf die leitende Schicht eines Ausschnittes einer vorfabrizierten Siliziumscheibe mit einer Fig. 2 entsprechenden Transistoranordnung,

Figur 4 die linienförmigen Abtragungen (Laser-Schnitte) auf dem Teilgebiet der Siliziumscheibe nach Fig. 3 zur Erzielung einer Schaltung gemäss Fig. 2,

Figur 5 das Teilgebiet nach Fig. 4 nach erfolgten linienförmigen Abtragungen, und

Figur 6 die im Teilgebiet Fig. 3 bis Fig. 5 verdeckt liegenden Transistoren der Schaltung gemäss Fig. 2.

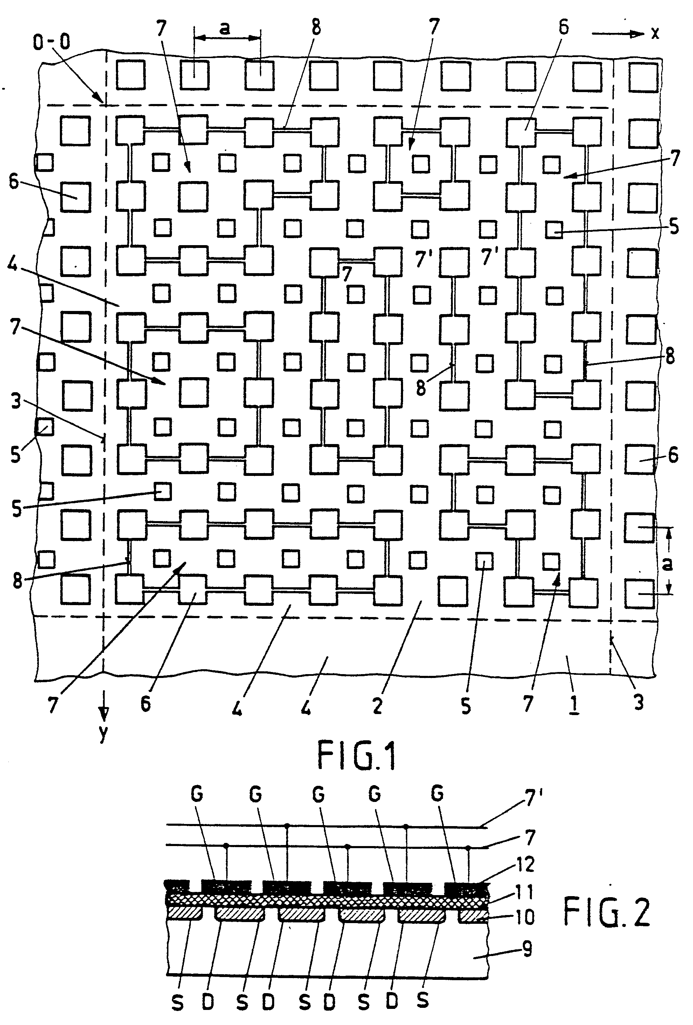

Gemäss Fig. 1 ist mit 1 eine vorfabrizierte Siliziumscheibe (Wafer) mit P- und N- resp. N- und P-Strukturen bezeichnet. Darauf ist, schematisch dargestellt, ein einzelnes Kristallplättchen (Chip) ersichtlich, welches durch mit gestrichelten Linien charakterisierten Trennstellen abgegrenzt ist.

Auf der Siliziumscheibe 1 befindet sich auf einer isolierenden Schicht eine, in bekannter Weise, aufgedampfte leitende Schicht 4 aus Aluminium. Partiell ist diese Schicht 4 mit Kontaktflächen 5 der Strukturen verbunden.

Die leitende Schicht 4 besitzt, nach einem vorgegebenen Raster aufgebaut, zusätzliche Aussparungen 6, welche isolierte Bereiche darstellen. Diese in einem Rasterabstand a vorhandenen Aussparungen sind mittels einer Standardmaske in einer an sich bekannten Photo-Ätztechnik erstellt worden.

Durch linienförmige Abtragungen 8 der leitenden Schicht 4 sind insulare leitende Bereiche 7, 7' gebildet worden, welche in entsprechender Weise mit aussenliegenden Kontakten verbunden werden.

Zur Herstellung dieser linienförmigen Abtragungen ist insbesondere eine Laser-Schneidmaschine (z. B. Modell 40 oder 80 von ESI, Portland/Oregan, USA) geeignet. Diese Maschine tastet mit ihrem Laser-Strahl die Oberfläche der Siliziumscheibe 1 ab, wobei als Orientierung ein Koordinaten-Nullpunkt 0-0 dient. Entsprechend einem Steuerprogramm wird der Laser-Strahl in der Horizontalebene zuerst in X-, nachher in Y-Richtung über die Oberfläche des Kristallplättchens 2 geführt. Der einzelne Abtastschritt entspricht einem Rasterabstand a. Der Laser-Strahl wird dabei intermittierend ein- und ausgeschaltet, so dass je nach Wunsch (Steuerprogramm) Materialabtragungen, bzw. Markierungen oder Belichtungen auf der Oberfläche des Kristallplättchens entstehen.

Entsprechend der gewählten Technik verwendet die eingesetzte Maschine einen CW-Laser (Continuous-Wave-Laser) höherer oder niedriger Leistung. Der Laser höherer Leistung dient zum direkten Schmelz- oder Sublimierschneiden der leitenden Schicht 4 und muss daher in seiner Leistung optimal auf diese Schicht abgestimmt sein. Ein Niedrigenergie-Laser (z. B. Spectra Physics International, Santa Clara, USA, Model 162 A, Scientific Air Cooled Argon Ion Laser) erlaubt die an sich bekannten Photo-Ätztechniken, welche auch bei der Herstellung der Standardmaske — mit den Aussparungen 5 — Verwendung finden, entweder im selben Arbeitsgang oder in einem zusätzlichen Arbeitsgang, einzusetzen.

Das aufgezeigte Verfahren ist in seiner Abwicklung besonders vorteilhaft, da der verwendete Strahl in praxi auf die Aussparungen 6 ausgerichtet werden kann, so dass die leitenden Bereiche 7, 7' besonders einfach und ohne Auftreten von Fehlern hergestellt werden können. Positionierungs- und/oder Winkelfehler bei der Steuerung des Strahls sind dabei in weiten Grenzen tolerierbar, ohne dass die Produktequalität dabei gefährdet wird.

Die Herstellung der galvanisch leitenden Bereiche lässt sich wie folgt erzielen :

Beispiel 1

Die zu bearbeitende Siliziumscheibe wird wahlweise mit negativ oder positiv arbeitendem Photoresist (Negativ- bzw. Positiv-Photoresist) beschichtet und über eine Standard-Fenstermaske, welche im Rasterabstand a angeordnete Fenster in der Grösse der Aussparung 6 aufweist, belichtet. Nach einem Ätzvorgang erfolgt das partielle Ablösen der Metallschicht (Strippen), worauf die Siliziumscheibe zwischengelagert wird.

Zur Herstellung einer spezifischen integrierten Schaltung wird die Siliziumscheibe mit positiv arbeitendem Photoresist (z. B. Microposit 23®, Shipley Company Inc., Massachusetts, USA) beschichtet, entsprechend den zu erzielenden linienförmigen Abtragungen mit einem Laser-Strahl belichtet, anschliessend geätzt und gestrippt.

Beispiel 2

Die Siliziumscheibe wird mit einem Positiv-Photoresist beschichtet, über die Standard-Fenstermaske belichtet, entwickelt, geätzt und die Scheibe lichtgeschützt zwischengelagert.

Zu gegebener Zeit erfolgt die Belichtung mit dem Laser-Strahl, eine weitere Entwicklung des Resists, sowie das Ätzen und Strippen der linienförmigen Abtragungen.

Beispiel 3

Die Siliziumscheibe wird mit Positiv-Photoresist beschichtet, über die Standard-Fenstermaske belichtet und lichtgeschützt zwischengelagert.

Nach der Belichtung mit dem Laser-Strahl wird der gesamte Photoresist entwickelt ; es wird anschliessend geätzt und gestrippt.

Beispiel 4

Die Siliziumscheibe wird mit Positiv-Photoresist beschichtet, über die Standard-Fenstermaske belichtet, der Photoresist entwickelt und lichtgeschützt zwischengelagert.

Nach der Belichtung mit dem Laser-Strahl wird der Photoresist nochmals entwickelt, geätzt und gestrippt.

Die Auswahl der geeignetsten Methode ist von der Art der Laser-Maschine, deren Steuerung und von der Dauer der Zwischenlagerung der Siliziumscheiben abhängig.

Die Herstellung der Aussparungen 6 und der linienförmigen Abtragungen 8 kann jedoch auch mit an sich ebenfalls bekannten Abtragungs- und/oder Auftragsprozessen erfolgen, wie beispielsweise durch laserunterstützte chemische Dampfablagerung (chemical vapor deposition), wobei der Laser seine Wirkung durch Photoanregung, Photoaufspalten oder lokale Erhitzung erreicht und durch laserunterstütztes Ätzen, z. B. durch die Aktivierung von gasförmigem Chlor-Ätzstoff durch Laserstrahlen.

In einer praktisch realisierten Anlage dient ein Koordinatentisch einer Schneidmaschine zur Zerlegung von Siliziumscheiben und Substraten (E-sec® Model 8002, Hünenberg, Schweiz) mit einer Computersteuerung zur Erzielung der zur Abtragung notwendigen linienförmigen Bewegungen in X- und Y-Richtung, während der CW-Laser-Strahl über ein elektrooptisches Modulationssystem (Coherent Associates, Danbury, USA), entsprechend dem individuellen Steuerprogramm (Software) geschaltet wird.

Anstelle einer Laser-Maschine lässt sich auch eine entsprechende Anordnung mit einem Elektronenstrahl oder einem elektromagnetischen Strahl einsetzen.

Das erfindungsgemässe Verfahren bzw. die entsprechende Anordnung sind vorwiegend für Logikschaltungen (Logic Arrays) geeignet, wie Steuernetzwerke, Takterzeugung und -verteilung, Zwischenspeicher, Schnittstellen zu Tastaturen und Schaltern, « Bus »-Steuerungen, Signalverteilung, « Handshaking » und Treiberstufen für LCD/LED — Anzeigen.

Diese Technologie wird am zweckmässigsten durch eine Bibliothek von logischen Standardfunktionen realisiert, wobei ein Transistorpaar (jeweils ein Transistor mit einem P-Kanal und einer mit einem N-Kanal) als eine Stufe betrachtet wird. Dadurch wird eine wirtschaftliche, rechnergestützte Konstruktion von Schaltkreisen aufgrund einer Wahrheitstabelle (Truth-Table) möglich. Die berechneten Daten dienen direkt zur Steuerung des Laser-Strahls bzw. des Koordinatentisches.

Wie das nachfolgende Beispiel jedoch zeigt, lassen sich auch Ladungsverschiebe-Schaltungen für Analoganwendungen realisieren. Eine schematisch dargestellte Halbleiteranordnung nach Fig. 2 zeigt deren schichtweisen Aufbau. Es handelt sich dabei um ein sogenanntes Bucket-Brigade-Device (BBD), deren Source mit S, Gate mit G, Drain mit D bezeichnet sind und wobei die leitenden Bereiche 7, 7' die Funktion von Taktleitungen besitzen. Dabei besteht eine mit D, S bezeichnete Struktur jeweils aus zwei Transistoren.

In einer n-dotierten Siliziumscheibe 9 befinden sich p+-dotierte Siliziumschichten 10, deren Kontaktstellen mit einer Siliziumoxidschicht 11 überzogen sind, auf welcher sich eine Aluminiumschicht 12 (leitende Schicht) befindet. Die zur Funktion der Anordnung notwendigen leitenden Bereiche 7, 7' sind vereinfacht durch Linien dargestellt.

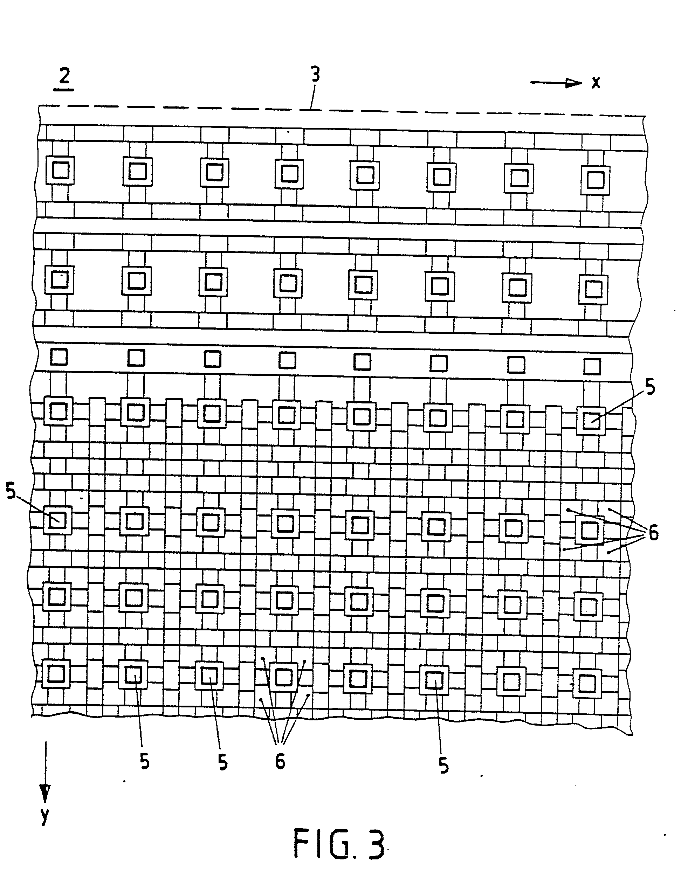

Zur Erzeugung einer Halbleiteranordnung Fig. 2 dient eine vorfabrizierte Siliziumscheibe mit einem Standard-Raster gemäss Fig. 3. Eine Trennstelle 3 ist wiederum gestrichelt dargestellt zur Abgrenzung des Gebietes eines einzelnen Kristallplättchens 2. Ersichtlich sind hier quadratisch ausgebildete Kontaktflächen 5 der Aluminiumschicht 12, Fig. 2, welche mit den darunterliegenden Strukturen leitende Verbindungen herstellen. Um diese Kontaktflächen 5 sind in einem entsprechenden Rasterabstand Aussparungen 6 — in sechseckiger Form — vorhanden.

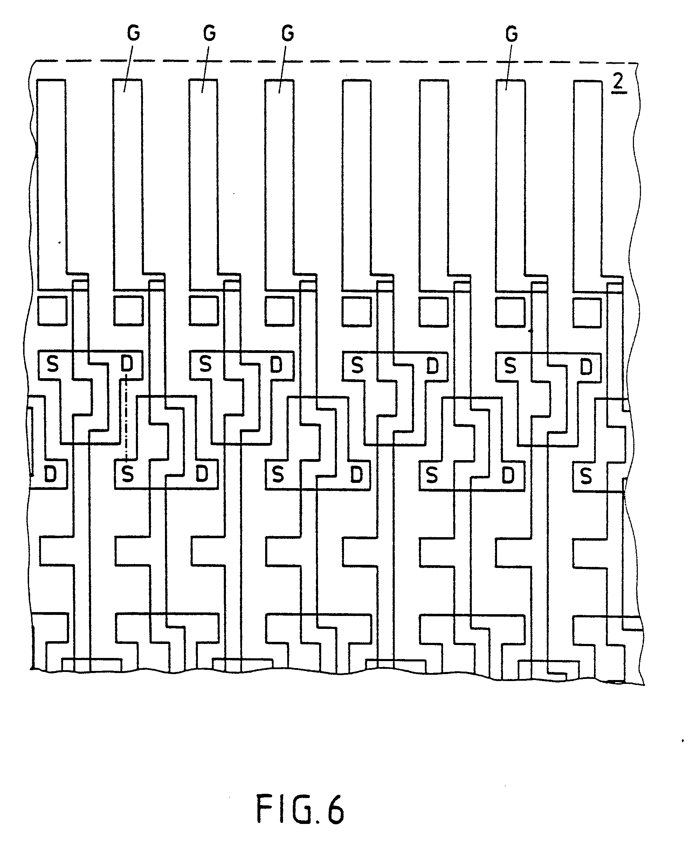

Diese vorfabrizierte Siliziumscheibe weist darunterliegende Halbleiterschichten auf (vgl. Fig. 6) und kann mittels linienförmigen Abtragungen der Aluminiumschicht in X- und Y-Richtung zu beliebig « langen » Eimerkettenschaltungen (Bucket-Brigade-Device) verarbeitet werden.

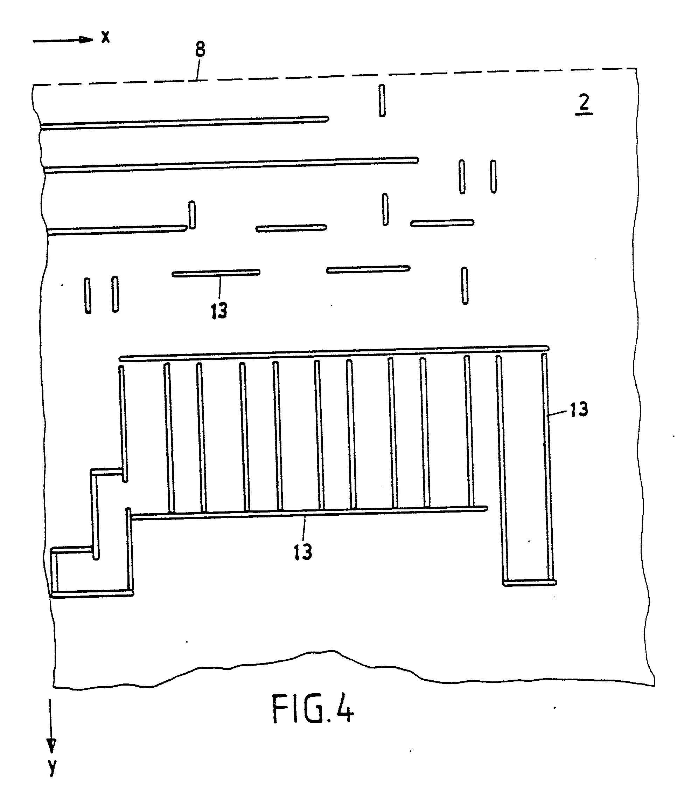

Dies ist in Fig. 4 dargestellt, wo die hierzu notwendige Strahlführung (Schnittbild) mit 13 bezeichnet ist. Konkret handelt es sich hierbei um die Bestrahlung mittels eines CW-Lasers mit einer Energie von 0,2 mW bei einer Wellenlänge von 458 nm mit einer Schreibgeschwindigkeit (mittleren Vorschubgeschwindigkeit) von 25 cm/sec., der eine einen Positiv-Photoresist (Microposit 23) aufweisende Oberfläche bestrahlt. Der Laser-Strahl des Argon Ionen Lasers wird dabei auf die Mitte der Aussparungen 6 ausgerichtet und entsprechend der Position des Koordinatentisches ein- und ausgeschaltet (Steuerprogramm).

Durch eine entsprechende Strahlbewegung und Steuerung kann selbstverständlich auch eine kinematische Umkehr zur Erzeugung des gleichen Schnittbildes realisiert werden (Tisch fest ; Strahl ausgelenkt).

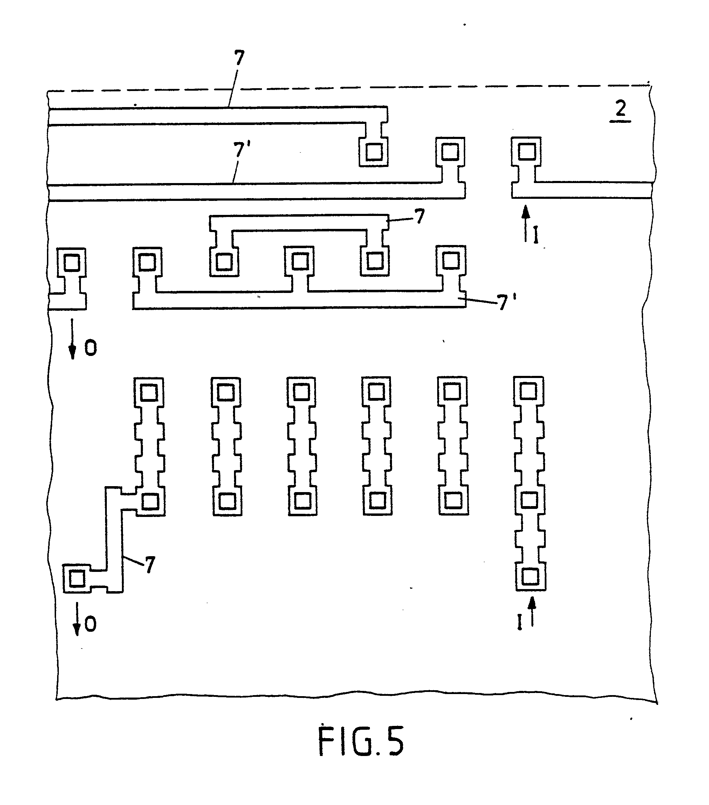

Die fertige Schaltungsanordnung (Fig. 2) ist aus Fig. 5 ersichtlich. Die leitenden Bereiche sind auch hier mit 7 und 7' bezeichnet. Die Eingänge der Schaltungsanordnung sind I

Bezeichnungsliste

1 = Siliziumscheibe (Wafer)
2 = Kristallplättchen (Chip)
3 = Trennstellen
4 = leitende Schicht (Al-Schicht)
5 = Kontaktflächen, mit 4 verbunden
6 = Aussparungen
7, 7' = leitende Bereiche
8 = linienförmige Abtragung
9 = n-Silizium
10 = p+-Silizium
11 = SiO2 (entspricht isolierender Schicht)
12 = Al (entspricht leitender Schicht 4)
13 = Schnittbild (Laser-Strahl)
S = Source
G = Gate
D = Drain
a = Raster (Abstand)
I = Eingang
O = Ausgang

(IN) und die Ausgänge O (Out).

Der Vollständigkeithalber sind in Fig. 6 in vereinfachter Form die Transistoren in den Diffusionsschichten dargestellt. Entsprechend Fig. 2 sind hier wiederum S (= Source) und G (= Gate) eingezeichnet. Symbolisch dargestellt mit einer Strich/Punkt-Linie ist eine jeweils zwischen zwei benachbarten Transistoren notwendige metallische Verbindung.

Wie anhand der Ausführungsbeispiele dargestellt wurde, kann somit auf einfachste Weise eine integrierte Schaltung, individuell oder anwendungsspezifisch, in ihrer Gesamtfunktion aus Normteilen mit standardisierten Aussparungen hergestellt werden.

Die vorgängig beschriebenen Techniken könnten auch auf mehrlagige, galvanisch leitende Schichten angewandt werden.

**Patentansprüche**

1. Verfahren zur Herstellung galvanisch leitender Bereiche (7, 7') in integrierten, monolythischen Halbleiteranordnungen auf einer vorfabrizierten Halbleiterscheibe (1) mit mehrfach vorhandenen P- und N- resp. N- und P-Strukturen, sowie über diesen Strukturen zumindest partiell regelmässig wiederkehrenden Kontaktflächen (5), wobei die Ebene der Kontaktflächen (5) durch eine erste, mit Aussparungen versehene, isolierende Schicht abgedeckt ist, auf welcher eine zweite, galvanisch leitende Schicht (4) aufgebracht ist, welche leitende Schicht (4) wenigstens partiell mit den Kontaktflächen (5) der Strukturen leitend verbunden ist, dadurch gekennzeichnet, dass in einem ersten Verfahrensschritt die galvanisch leitende Schicht (4) mit Aussparungen (6) in einem vorgebenen Raster hergestellt wird, deren Rasterabstand (a) zumindest annähernd der minimalen Breite eines zu erzielenden galvanisch leitenden Bereichs (7, 7') entspricht, und dass in einem zweiten Verfahrensschritt die leitende Schicht (4) im Gebiet hintereinander angeordneter Aussparungen (6) soweit linienförmig abgetragen wird, bis ein insularer leitender Bereich (7, 7') entsteht.

2. Verfahren nach Anspruch 1, dadurch gekennzeichnet, dass die linienförmige Abtragung (8) direkt oder indirekt durch einen Laser-Strahl erzeugt wird.

3. Verfahren nach Anspruch 2, dadurch gekennzeichnet, dass der Laser-Strahl zur Belichtung einer photosensitiven Schicht eingesetzt wird.

4. Verfahren nach Anspruch 2, dadurch gekennzeichnet, dass der Laser-Strahl zum Schmelz- oder Sublimierschneiden der galvanisch leitenden Schicht (4) eingesetzt wird.

5. Verfahren nach Anspruch 1, dadurch gekennzeichnet, dass die linienförmige Abtragung (8) direkt oder indirekt durch einen Elektronen- oder elektromagnetischen Strahl erzeugt wird.

6. Verfahren nach Anspruch 1, dadurch gekennzeichnet, dass die Aussparungen (6) durch einen Abtragungs- und/oder Auftragsprozess erzeugt werden.

7. Integrierte monolythische Halbleiteranordnung hoher Packungsdichte mit mehrfach vorhandenen P- und N- resp. N- und P-Strukturen, sowie über diesen Strukturen zumindest partiell regelmässig wiederkehrende Kontaktflächen (5), wobei die Ebene der Kontaktflächen (5) durch eine erste, mit Aussparungen versehene, isolierende Schicht abgedeckt ist, auf welcher eine zweite galvanisch leitende Schicht (4) aufgebracht ist, welche leitende Schicht (4) wenigstens partiell mit den Kontaktflächen (5) der Strukturen leitend verbunden ist, dadurch gekennzeichnet, dass die galvanisch leitende Schicht (4) in einem vorgegebenen Raster angeordnete Aussparungen (6) enthält, und dass diese Aussparungen (6) End-, Verbindungs- und/oder Eckpunkte insularer leitender Bereiche sind, wobei diese Aussparungen (6) durch linienförmige Aussparungen (8) in der galvanisch leitendem Schicht (4) miteinander verbunden sind.

8. Integrierte monolythische Halbleiteranordnung nach Anspruch 7, dadurch gekennzeichnet, dass die in einem vorgegebenen Raster angeordneten Ausparungen (6) stardardisiert sind.

## Claims

1. A method of forming electroconductive domains (7, 7') in integrated monolithic semiconductor devices on a prefabricated semiconductor wafer (1) with a plurality of p- and n- or n- and p-structures respectively, and contact surfaces (5) regularly recurring at least in part over these structures, the plane of the contact surfaces (5) being covered by a first insulating layer which is provided with openings and on which is disposed a second, electroconductive layer (4) which is conductively connected at least in part to the contact surfaces (5) of the structures, characterized in that in a first method step the electroconductive layer (4) is formed with openings (6) in a predetermined grid whose grid spacing (a) corresponds at least approximately to the minimum width of an electroconductive domain to be produced, and in a second method step the conductive layer (4) is removed in a linear manner in the region of successive openings (6), until an insular conductive domain (7, 7') is produced.

2. A method according to claim 1, characterized in that the linear removal (8) is carried out directly or indirectly by a laser beam.

3. A method according to claim 2, characterized in that the laser beam is used for illuminating a photosensitive layer.

4. A method according to claim 2, characterized in that the laser beam is used for melting cutting or sublimation cutting of the electroconductive layer (4).

5. A method according to claim 1, characterized in that the linear removal (8) is carried out directly or indirectly by an electron beam or electromagnetic beam.

6. A method according to claim 1, characterized in that the openings (6) are produced by a removal and/or coating process.

7. An integrated monolithic semiconductor device of high package density with a plurality of p- and n- or n- and p-structures, and contact surfaces (5) regularly recurring at least in part over these structures, the plane of the contact surfaces (5) being covered by a first insulating layer which is provided with openings and on which is disposed a second, electroconductive layer (4) which is conductively connected at least in part to the contact surfaces (5) of the structures, characterized in that the electroconductive layer (4) comprises openings (6) arranged in a predetermined grid, and the said openings (6) are end-, connection- and/or corner-points of insular conductive domains, the said openings (6) being connected to one another by linear removed portions in the electroconductive layer (4).

8. An integrated monolithic semiconductor circuit according to claim 7, characterized in that the openings (6) arranged in a predetermined grid are standardized.

## Revendications

1. Procédé pour fabriquer des domaines (7, 7') électriquement conducteurs dans des dispositifs à semi-conducteurs intégrés monolithiques sur une galette de semi-conducteurs (1) préfabriquée comportant des structures répétitives P et N et/ou N et P respectivement, ainsi que des surfaces de contact (5) disposées au-dessus de ces structures de façon au moins partiellement régulièrement répétitive, le plan des surfaces de contact (5) étant recouvert par une première couche isolante munie d'évidements, sur laquelle est appliquée une seconde couche (4) électriquement conductrice, laquelle couche conductrice (4) est reliée au moins partiellement aux surfaces de contact (5) des structures, caractérisé en ce que, dans une première phase du procédé, la couche électriquement conductrice (4) est fabriquée avec des évidements (6) selon une grille prédéterminée, dont l'intervalle de grille (a) correspond au moins approximativement à la largeur minimale d'un domaine électriquement conducteur (7, 7') qu'on veut obtenir, et en ce que, dans une seconde phase du procédé, la couche conductrice (4) est enlevée en forme de lignes dans des évidements (6) disposés l'un derrière l'autre, jusqu'à ce qu'il en résulte un domaine insulaire conducteur (7, 7').

2. Procédé selon la revendication 1, caractérisé en ce que l'enlèvement linéaire (8) est produit directement ou indirectement par un rayon laser.

3. Procédé selon la revendication 2, caractérisé en ce que le rayon laser est utilisé pour exposer une couche photosensible.

4. Procédé selon la revendication 2, caractérisé en ce que le rayon laser est utilisé pour couper par fusion ou sublimation la couche électriquement conductrice (4).

5. Procédé selon la revendication 1, caractérisé en ce que l'enlèvement linéaire (8) est produit directement ou indirectement par rayonnement électronique et électromagnétique.

6. Procédé selon la revendication 1, caractérisé en ce que les évidements (6) sont produits par un processus d'enlèvement et/ou d'application.

7. Dispositif à semi-conducteurs monolithique intégré à densité d'empilage élevée comportant des structures P et N et/ou N et P respectivement se présentant de façon répétitive, ainsi que des surfaces de contact (5) disposées au-dessus de ces structures de façon au moins partiellement régulièrement répétitive, le plan des surfaces de contact étant recouvert par une première couche isolante munie d'évidements, sur laquelle est appliquée une seconde couche (4) électriquement conductrice, laquelle couche conductrice (4) est reliée au moins partiellement aux surfaces de contact (5) des structures, caractérisé en ce que la couche électriquement conductrice (4) comporte des évidements (6) disposés selon une grille prédéterminée, et ces évidements (6) sont les points terminaux, les points de liaison et/ou les points d'angles de domaines conducteurs insulaires, ces évidements (6) étant reliés ensemble par des enlèvements linéaires (8) dans la couche électriquement conductrice.

8. Dispositif à semi-conducteurs monolithique intégré selon la revendication 7, caractérisé en ce que les évidements (6) disposés selon une grille prédéterminée, sont standardisés.

FIG.1

FIG.2

FIG. 3

X

8

2

13

13

13

## FIG.4

Y

FIG.5

FIG.6